# EUROPÄISCHE PATENTSCHRIFT

(11) **EP 1 093 909 B1**
(45) Veröffentlichungstag und Bekanntmachung des Hinweises auf die Patenterteilung: **15.10.2003**
(21) Anmeldenummer: 00114514.3
(22) Anmeldetag: 06.07.2000
(51) Int. Cl.: B32B 3/24, B32B 31/00, G06K 19/02, H01L 23/00, H05K 3/00, H01L 23/498, H05K 3/38

(54) **Folienverbund**
Composite film
Feuille composite

(30) Priorität: 22.10.1999 DE 19951164
(43) Veröffentlichungstag der Anmeldung: 25.04.2001
(73) Patentinhaber: W.C. Heraeus GmbH & Co. KG, 63450 Hanau (DE)
(72) Erfinder: Herklotz, Günter, Dr., 63456 Bruchköbel (DE); Rabe, Michael, 63486 Bruchköbel (DE)
(74) Vertreter: Kühn, Hans-Christian

(56) Entgegenhaltungen:
- DE-A- 4 442 920
- DE-A- 19 521 022
- DE-A- 19 632 795
- DE-C- 4 340 996

## Beschreibung

Die Erfindung betrifft einen Folienverbund aus mindestens zwei Folienbahnen, wobei mindestens eine Folienbahn der mindestens zwei Folienbahnen aus einer Metallfolie oder einer Kunststoff-Folie gebildet ist und mindestens eine weitere Folienbahn der mindestens zwei Folienbahnen aus einer beidseitig klebeaktiven Heißkleber-Folie gebildet ist, ein Verfahren zur Herstellung eines Folienverbundes aus mindestens zwei Folienbahnen, wobei mindestens eine Folienbahn der mindestens zwei Folienbahnen aus einer Metallfolie oder einer Kunststoff-Folie gebildet wird und mindestens eine weitere Folienbahn der mindestens zwei Folienbahnen aus einer Transferfolie gebildet wird, wobei die Transferfolie aus einer Trägerfolie und einer beidseitig klebeaktiven Heißkleber-Folie gebildet ist sowie die Verwendung einer strukturierten Heißkleber- oder Transferfolie.

Die DE 195 21 022 C2 beschreibt ein Verfahren zur Herstellung eines Schichtverbundes, insbesondere zur Verwendung für IC-Karten. Dabei werden mindestens zwei langgestreckte Folienbahnen nacheinander einer Stanzeinrichtung zugeführt und mit unterschiedlichen Stanzstrukturen und identischen Positionierungsmarken versehen. Die Folienbahnen werden anschließend mittels Führungseinrichtungen, die die Positionierungsmarken der Folienbahnen lagerichtig übereinanderlegen, zusammengeführt und zur Fixierung ihrer Lage geheftet. Nachfolgend werden die zusammengehefteten Folienbahnen einer Laminiereinrichtung zugeführt und der endgültige Schichtverbund bei einer Temperatur von etwa 180°C hergestellt. Im speziellen wird die Herstellung eines Schichtverbundes aus einer Metallbahn und einer glasfaserverstärkten Kunststoffbahn beschrieben, aber auch andere Kunststoffbahnen ohne Faserverstärkung sind verwendbar.
Auch die DE 44 42 920 A1 beschreibt ein Verfahren zur Herstellung eines Folienverbundes aus einer Metallfolie und einer Kunststoff-Folie, wobei vereinzelte Folienabschnitte verwendet werden. Als Klebstoff dient herkömmlicher Heißkleber, wie zum Beispiel ein Zweikomponentenepoxidharz. Übliche Kunststoff-Folien weisen auf einer Seite der Folie eine dünne Schicht heißklebenden Materials auf, welches in der Laminiereinrichtung aufschmilzt und zur Ausbildung der Klebeverbindung zwischen der Kunststoff-Folie und der Metallfolie dient. Die andere Seite der Kunststoff-Folie ist unbeschichtet und wird später, beispielsweise unter Verwendung von schnell härtendem Kleber ( Sekundenkleber ), in IC-Karten eingeklebt. Damit diese unbeschichtete Seite der Kunststoff-Folie eine Klebeverbindung gleich welcher Art eingeht, muss sie zuvor beispielsweise in einer Sandstrahlanlage gereinigt und aktiviert werden. Diese Aktivierung bleibt je nach Auswahl der Kunststoff-Folie unterschiedlich lange erhalten. Während beispielsweise die Aktivierung spezieller glasfaserverstärkter Kunststoffbänder unbegrenzt lange erhalten bleibt, dauert die Aktivierung anderer Kunststoffe oft nur wenige Wochen an und es ergibt sich eine zeitlich begrenzte Verarbeitbarkeit und Lagerfähigkeit. Die speziellen glasfaserverstärkten Kunststoff-Folien wiederum sind in der Herstellung kompliziert und daher hochpreisig.

Es stellt sich damit das Problem, die Weiterverarbeitbarkeit von Folienverbunden zu verbessern und ihre Herstellung zu vereinfachen.

Das Problem wird für den Folienverbund dadurch gelöst, dass die mindestens eine als Metallfolie oder Kunststoff-Folie ausgebildete Folienbahn strukturiert ist, dass die als Heißkleber-Folie ausgebildete Folienbahn strukturiert ist und dass mindestens die Strukturierung derjenigen Metallfolien oder Kunststoff-Folien, die im Folienverbund an die Heißkleber-Folie angrenzen, zumindest teilweise unterschiedlich zu der Strukturierung der Heißkleber-Folie ist.
Das Problem wird für den Folienverbund weiterhin dadurch gelöst, dass die mindestens eine als Metallfolie oder Kunststoff-Folie ausgebildete Folienbahn strukturiert ist, dass die als Heißkleber-Folie ausgebildete Folienbahn zumindest teilweise identisch strukturiert ist und dass die Strukturierung der Metallfolien oder der Kunststoff-Folien, die im Folienverbund an die Heißkleber-Folie angrenzen, zumindest in einem Teilbereich der identischen Strukturierung versetzt zur Strukturierung der Heißkleber-Folie angeordnet ist.

Unter einer "Strukturierung" wird dabei das Einbringen von Unterbrechungen beziehungsweise von irgendwie gearteten Löchern, Einschnitten oder Durchbrüchen in eine Folienbahn verstanden, wobei sich diese Unterbrechungen über die gesamte Dicke der Folienbahn erstrecken. Unter angrenzenden Folienbahnen werden dabei nur solche verstanden, die im Folienverbund in Kontakt zu den Oberflächen der jeweils betrachteten Heißkleber-Folie stehen.

Eine solche Heißkleber-Folie ist mechanisch wenig stabil und daher nur auf einer speziellen Trägerfolie in Form einer sogenannten Transferfolie ( Hersteller zum Beispiel: DuPont) erhältlich und verarbeitbar. Diese Transferfolie kann erstaunlicherweise strukturiert werden, ohne dass es zu Verwerfungen oder Ablösungen der Heißkleber-Folie kommt. Die Strukturierung der Transferfolie und damit der Heißkleber-Folie kann bevorzugt durch Stanzen, aber auch mit Hilfe eines Lasers erfolgen. Dabei sind für das Stanzbild hervorragende Toleranzen von < 50µm erreichbar. Das lagerichtige Zusammenführen der unterschiedlichen Folienbahnen mit der strukturierten Transferfolie ist passgenau mit einer Toleranz < 100µm ausführbar. Dies ist insbesondere beim Laminieren von Folienbahnen mit einer Länge von > 1 m, insbesondere aber mit einer Länge > 50m von großer Bedeutung. Es können hier jedoch auch noch problemlos Folienbahnen mit Längen über 350m verarbeitet werden. Nach dem Zusammenführen, Heften und Laminieren einer strukturierten Transferfolie mit einer weiteren strukturierten Folienbahn kann die Trägerfolie von der Heißkleber-Folie abgezogen werden. Die nun freiliegende zweite Seite der Heißkleber-Folie ist unter Wärmeeinwirkung klebeaktiv und kann direkt zum Einkleben des Folienverbundes in beispielsweise PVC-Karten beziehungsweise zur Herstellung von IC-Karten verwendet werden. Ein Aktivieren oder das Aufbringen von schnell härtendem Kleber, wie es für gebräuchliche Kunststoff-Folien teilweise unabdingbar ist, erübrigt sich damit. Zudem kann die Kunststoff-Folie eingespart werden, was beispielsweise bei Weglassen einer glasfaserverstärkten Kunststoff-Folie die Herstellungskosten für einen Folienverbund um einen Faktor 2 bis 3 senkt. Nach dem Laminieren der Folienbahnen wirkt die Heißkleber-Folie trotz ihrer geringen Schichtdicke stabilisierend und verleiht dem Folienverbund ausreichende Festigkeit für weitere Verarbeitungsschritte. Die Strukturierung in einer auflaminierten Heißkleber-Folie kann schließlich genutzt werden, um eine Art Maske für die darunter frei liegende Folienbahn ( beispielsweise zur Abscheidung galvanischer Schichten oder zum Auftrag pastöser oder flüssiger Materialien innerhalb der Strukturierung aber auch für Ätzvorgänge in gasförmigen Atmosphären ) zu erhalten.
So ist der Folienverbund in einer vorteilhaften Ausgestaltung der Erfindung aus mindestens einer strukturierten Heißkleber-Folie und mindestens einer strukturierten Metallfolie gebildet. Diese Metallfolien können eine Dicke im Bereich von beispielsweise 20µm bis 200µm aufweisen. Vorteilhaft ist jedoch eine Dicke im Bereich von 30µm bis 100µm. Transferfolien sind mit Heißkleber-Folien der Dicke 25µm und 50µm erhältlich, aber auch dickere Heißkleber-Folien sind verwendbar. Im Vergleich zu einer beispielsweise mit Kleber beschichteten glasfaserverstärkten Kunststoff-Folie, die insgesamt eine Dicke im Bereich von etwa 80µm bis 125µm aufweist, ist erkennbar, dass mit der Heißkleber-Folie deutliche Dickeneinsparungen realisierbar sind. Insbesondere in der auf größtmögliche Miniaturisierung ausgelegten IC-Kartentechnik eröffnen sich damit neue Möglichkeiten.
Aber auch ein Folienverbund aus mindestens einer Metallfolie, mindestens einer Kunststoff-Folie und mindestens einer Heißkleber-Folie ist noch von Vorteil, da die aktivierte Oberfläche einer Kunststoff-Folie sofort mit einer Heißkleber-Folie verbunden werden kann und eine nachträgliche Verwendung von beispielsweise Sekundenkleber nicht mehr erforderlich ist. So können auch mehrere Heißkleber-Folien zur Herstellung eines Folienverbundes verwendet werden, indem sie als Zwischenschichten zwischen diversen Metall- und / oder Kunststoff-Folien verwendet werden. Möglich ist auch die Verwendung einer Heißkleber-Folie, bei welcher der Heißkleber einen elektrisch nicht leitenden Füllstoff wie beispielsweise Kunststoff-Fasern, Glas- oder Keramik-Partikel oder ähnliches enthält. Dabei kann der Füllstoff-Anteil im Heißkleber bis zu 50 Vol.-% betragen.

Das Problem wird für das Verfahren dadurch gelöst, dass die mindestens zwei Folienbahnen jeweils strukturiert werden, dass die strukturierte Transferfolie mit einer als Metallfolie oder Kunststoff-Folie ausgebildeten, zumindest teilweise unterschiedlich zur Transferfolie strukturierten Folienbahn lagerichtig zusammengeführt wird, dass die Transferfolie mit der Heißkleber-Folie auf die als Metallfolie oder Kunststoff-Folie ausgebildete Folienbahn auflaminiert wird und dass anschließend die Trägerfolie von der Heißkleber-Folie abgezogen wird.
Das Problem wird für das Verfahren weiterhin dadurch gelöst, dass die mindestens zwei Folienbahnen jeweils strukturiert werden, dass die strukturierte Transferfolie mit einer als Metallfolie oder Kunststoff-Folie ausgebildeten, zumindest teilweise identisch zur Transferfolie strukturierten Folienbahn lagerichtig zusammengeführt wird, wobei die Strukturierung der Metallfolie oder Kunststoff-Folie zumindest in einem Teibereich der identischen Strukturierung versetzt zu der Strukturierung der Transferfolie angeordnet wird, dass die Transferfolie mit der Heißkleber-Folie auf die als Metallfolie oder Kunststoff-Folie ausgebildete Folienbahn auflaminiert wird und dass anschließend die Trägerfolie von der Heißkleber-Folie abgezogen wird.

Die erfindungsgemäßen Verfahren ermöglichen durch die Strukturierung der Transferfolie und damit der Heißkleber-Folie vor dem Laminieren die Herstellung besonders dünner Folienverbunde. Während bisher nur die gemeinsame Strukturierung einer dünnen Kleberschicht gemeinsam mit einer den Kleber tragenden Metall- oder Kunststoff-Folie bekannt war und damit die Kleberschicht immer wenigstens mit einer angrenzenden Folie eine identische Strukturierung aufwies, ermöglicht es das erfindungsgemäße Verfahren, dass im fertigen Folienverbund alle direkt an die strukturierte Heißkleber-Folie angrenzenden Metall- oder Kunststoff-Folien unterschiedlich strukturiert sein können

Besonders bewährt hat es sich, wenn die Transferfolie durch Stanzen strukturiert wird. Aber auch durch einen Laser kann sehr toleranzgenau strukturiert werden. Besonders erstaunlich ist es, dass die erfindungsgemäßen Verfahren sich eignen, strukturierte Folienbahnen mit einer Länge von > 1m, insbesondere aber mit einer Länge > 50m zu verarbeiten. Es können hier jedoch auch noch problemlos Folienbahnen mit Längen über 350m verarbeitet werden. Die strukturierten Folienbahnen können dabei mit einer Toleranz < 100µm passgenau aufeinander laminiert werden.

Es hat sich bewährt, die strukturierte Transferfolie auf eine strukturierte Metallfolie aufzulaminieren. Aber auch das Auflaminieren auf eine strukturierte Kunststoff-Folie oder einen Folienverbund ist möglich.

Die erfindungsgemäße Verwendung einer strukturierten Heißkleber-Folie oder einer strukturierten Transferfolie für die Herstellung eines Folienverbundes ist in hohem Maße kostensenkend. Insbesondere die Verwendung der strukturierten Heißkleber-Folie oder der strukturierten Transferfolie für die Herstellung von Folienverbunden für IC-Karten, die als Massenartikel in hohen Stückzahlen hergestellt werden, ist rentabel. Aber auch Folienverbunde für Halbleitersubstrate können unter Verwendung der strukturierten Heißkleber-Folie oder der strukturierten Transferfolie kostengünstig hergestellt werden.

Folgende Figuren sollen die Erfindung beispielhaft erläutern:
- Fig. 1:: Folienverbund aus strukturierter Metallfolie und strukturierter Heißkleber-Folie
- Fig. 2:: Folienverbund aus strukturierter Metallfolie, strukturierter Kunststoff-Folie und strukturierter Heißkleber-Folie
- Fig. 3:: Folienverbund aus strukturierter Metallfolie, strukturierter Heißkleber-Folie, strukturierter Kunststoff-Folie und einer weiteren strukturierten Heißkleber-Folie

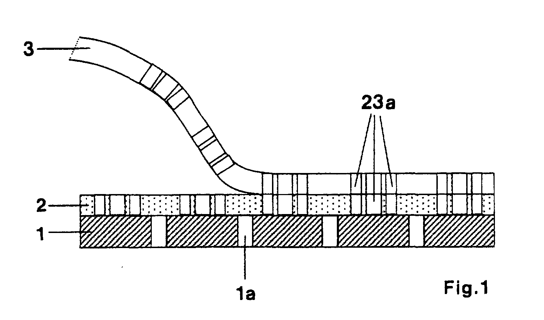

Fig. 1 zeigt einen Ausschnitt aus einem bandförmigen Folienverbund mit einer Metallfolie 1 und einer darauf laminierten Transferfolie, die aus einer Heißkleber-Folie 2 und einer Trägerfolie 3 besteht. Die Metallfolie 1 und die Transferfolie sind, beispielsweise durch einen Stanzvorgang, jeweils mit unterschiedlichen Strukturierungen 1a und 23a versehen . Nachdem die Verbindung zwischen der Metallfolie 1 und der Heißkleber-Folie 2 hergestellt ist, kann die Trägerfolie 3 von der Heißkleber-Folie 2 abgezogen werden. Die freiliegende Heißkleber-Folie 2 kann in diesem Zustand durch Laminieren beispielsweise mit einem IC-Kartenkörper aus PVC verbunden werden.

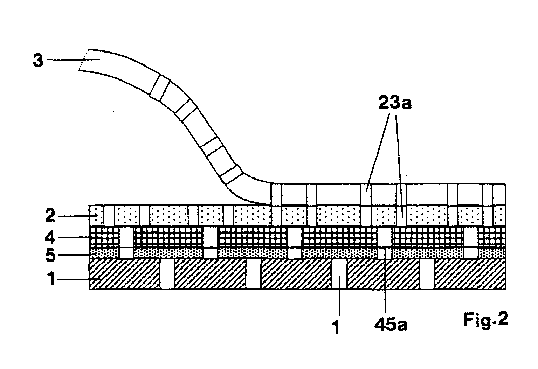

Fig. 2 zeigt einen Ausschnitt aus einem bandförmigen Folienverbund mit einer Metallfolie 1, einer glasfaserverstärkten Kunststoff-Folie 4 und einer darauf laminierten Transferfolie, die aus einer Heißkleber-Folie 2 und einer Trägerfolie 3 besteht. Die Metallfolie 1, die glasfaserverstärkte Kunststoff-Folie 4 und die Transferfolie sind, beispielsweise durch einen Stanzvorgang, jeweils mit unterschiedlichen Strukturierungen 1a; 23a; 45a versehen. Auf der glasfaserverstärkten Kunststoff-Folie 4 befindet sich einseitig eine Kleberschicht 5, die auf die Metallfolie 1 laminiert wird. Gleichzeitig oder aber in einem zweiten Laminierschritt wird die Transferfolie auf die glasfaserverstärkte Kunststoff-Folie 4 laminiert. Nun kann die Trägerfolie 3 von der Heißkleber-Folie 2 abgezogen werden. Die freiliegende Heißkleber-Folie 2 kann in diesem Zustand durch Laminieren beispielsweise mit einem IC-Kartenkörper aus PVC verbunden werden.

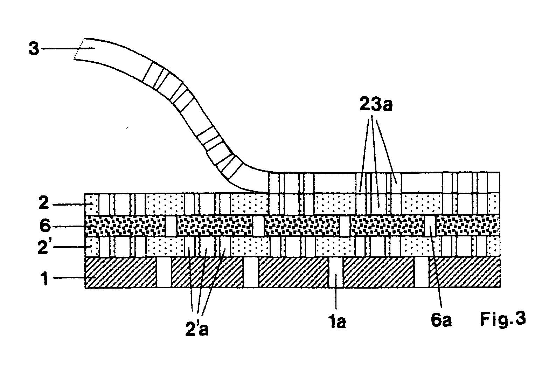

Fig. 3 zeigt einen Ausschnitt aus einem bandförmigen Folienverbund mit einer Metallfolie 1, einer Heißkleber-Folie 2', einer Kunststoff-Folie 6 und einer darauf laminierten Transferfolie, die aus einer Heißkleber-Folie 2 und einer Trägerfolie 3 besteht. Die Metallfolie 1, die Kunststoff-Folie 6 und die Transferfolien wurden, beispielsweise durch einen Stanzvorgang, jeweils mit Strukturen 1 a; 6a; 2'a; 23a versehen. Nachdem eine Verbindung zwischen der Metallfolie 1 und der Heißkleber-Folie 2' hergestellt ist, kann die Trägerfolie ( hier nicht gezeigt ) von der Heißkleber-Folie 2' abgezogen werden. Auf die Heißkleber-Folie 2'wird eine Kunststoff-Folie 6 laminiert, auf die wiederum eine Transferfolie laminiert wird. Die Trägerfolie 3 dieser Transferfolie kann anschließend von der Heißkleber-Folie 2 abgezogen werden.

## Patentansprüche

1. Folienverbund aus mindestens zwei Folienbahnen, wobei mindestens eine Folienbahn der mindestens zwei Folienbahnen aus einer Metallfolie oder einer Kunststoff-Folie gebildet ist und mindestens eine weitere Folienbahn der mindestens zwei Folienbahnen aus einer beidseitig klebeaktiven Heißkleber-Folie gebildet ist, **dadurch gekennzeichnet, dass** die mindestens eine als Metallfolie (1) oder Kunststoff-Folie (4; 6) ausgebildete Folienbahn strukturiert ist, **dass** die als Heißkleber-Folie (2; 2') ausgebildete Folienbahn strukturiert ist und **dass** mindestens die Strukturierung derjenigen Metallfolien (1) oder Kunststoff-Folien (4; 6), die im Folienverbund an die Heißkleber-Folie (2 ; 2') angrenzen, zumindest teilweise unterschiedlich zu der Strukturierung der Heißkleber-Folie (2 ; 2') ist.

2. Folienverbund aus mindestens zwei Folienbahnen, wobei mindestens eine Folienbahn der mindestens zwei Folienbahnen aus einer Metallfolie oder einer Kunststoff-Folie gebildet ist und mindestens eine weitere Folienbahn der mindestens zwei Folienbahnen aus einer beidseitig klebeaktiven Heißkleber-Folie gebildet ist, **dadurch gekennzeichnet, dass** die mindestens eine als Metallfolie (1) oder Kunststoff-Folie (4; 6) ausgebildete Folienbahn strukturiert ist, **dass** die als Heißkleber-Folie (2; 2') ausgebildete Folienbahn zumindest teilweise identisch strukturiert ist und **dass** die Strukturierung der Metallfolien (1) oder der Kunststoff-Folien (4; 6), die im Folienverbund an die Heißkleber-Folie (2;2') angrenzen, zumindest in einem Teilbereich der identischen Strukturierung versetzt zur Strukturierung der Heißkleber-Folie (2; 2') angeordnet ist.

3. Folienverbund nach einem der Ansprüche 1 oder 2, **dadurch gekennzeichnet, dass** der Folienverbund aus mindestens einer strukturierten Heißkleber-Folie (2; 2') und mindestens einer strukturierten Metallfolie (1) gebildet ist.

4. Folienverbund nach einem der Ansprüche 1 bis 3, **dadurch gekennzeichnet, dass** der Folienverbund aus mindestens einer strukturierten Metallfolie (1), mindestens einer strukturierten Kunststoff-Folie (4; 6) und mindestens einer strukturierten Heißkleber-Folie (2; 2') gebildet ist.

5. Folienverbund nach einem der Ansprüche 1 bis 4, **dadurch gekennzeichnet, dass** der Heißkleber der Heißkleber-Folie einen elektrisch nicht leitenden Füllstoff enthält.

6. Folienverbund nach einem der Ansprüche 1 bis 5, **dadurch gekennzeichnet, dass** die Heißkleber-Folie durch Stanzen strukturiert ist.

7. Folienverbund nach einem der Ansprüche 1 bis 5, **dadurch gekennzeichnet, dass** die Heißkleber-Folie durch einen Laser strukturiert ist.

8. Folienverbund nach einem der Ansprüche 1 bis 7, **dadurch gekennzeichnet, dass** die strukturierten Folienbahnen eine Länge von > 1m aufweisen.

9. Folienverbund nach Anspruch 8, **dadurch gekennzeichnet, dass** die strukturierten Folienbahnen eine Länge von > 50m aufweisen.

10. Folienverbund nach einem der Ansprüche 1 bis 9, **dadurch gekennzeichnet, dass** die strukturierten Folienbahnen mit einer Toleranz < 100µm passgenau aufeinander laminiert sind.

11. Verfahren zur Herstellung eines Folienverbundes aus mindestens zwei Folienbahnen, wobei mindestens eine Folienbahn der mindestens zwei Folienbahnen aus einer Metallfolie oder einer Kunststoff-Folie gebildet wird und mindestens eine weitere Folienbahn der mindestens zwei Folienbahnen aus einer Transferfolie gebildet wird, wobei die Transferfolie aus einer Trägerfolie und einer beidseitig klebeaktiven Heißkleber-Folie gebildet ist, **dadurch gekennzeichnet, dass** die mindestens zwei Folienbahnen jeweils strukturiert werden, **dass** die strukturierte Transferfolie mit einer als Metallfolie (1) oder Kunststoff-Folie (4; 6) ausgebildeten, zumindest teilweise unterschiedlich zur Transferfolie strukturierten Folienbahn lagerichtig zusammengeführt wird, **dass** die Transferfolie mit der Heißkleber-Folie (2; 2') auf die als Metallfolie (1) oder Kunststoff-Folie (4; 6) ausgebildete Folienbahn auflaminiert wird und dass anschließend die Trägerfolie (3) von der Heißkleber-Folie (2; 2') abgezogen wird.

12. Verfahren zur Herstellung eines Folienverbundes aus mindestens zwei Folienbahnen, wobei mindestens eine Folienbahn der mindestens zwei Folienbahnen aus einer Metallfolie oder einer Kunststoff-Folie gebildet wird und mindestens eine weitere Folienbahn der mindestens zwei Folienbahnen aus einer Transferfolie gebildet wird, wobei die Transferfolie aus einer Trägerfolie und einer beidseitig klebeaktiven Heißkleber-Folie gebildet ist, **dadurch gekennzeichnet, dass** die mindestens zwei Folienbahnen jeweils strukturiert werden, **dass** die strukturierte Transferfolie mit einer als Metallfolie (1) oder Kunststoff-Folie (4; 6) ausgebildeten, zumindest teilweise identisch zur Transferfolie strukturierten Folienbahn lagerichtig zusammengeführt wird, wobei die Strukturierung der Metallfolie (1) oder Kunststoff-Folie (4; 6) zumindest in einem Teilbereich der identischen Strukturierung versetzt zu der Strukturierung der Transferfolie angeordnet wird, **dass** die Transferfolie mit der Heißkleber-Folie (2; 2') auf die als Metallfolie (1) oder Kunststoff-Folie (4; 6) ausgebildete Folienbahn auflaminiert wird und **dass** anschließend die Trägerfolie (3) von der Heißkleber-Folie (2; 2') abgezogen wird.

13. Verfahren nach einem der Ansprüche 11 oder 12, **dadurch gekennzeichnet, dass** die Transferfolie durch Stanzen strukturiert wird.

14. Verfahren nach einem der Ansprüche 11 oder 12, **dadurch gekennzeichnet, dass** die Transferfolie durch einen Laser strukturiert wird.

15. Verfahren nach einem der Ansprüche 11 bis 14, **dadurch gekennzeichnet, dass** strukturierte Folienbahnen mit einer Länge von > 1 m verwendet werden.

16. Verfahren nach einem der Ansprüche 11 bis 15, **dadurch gekennzeichnet, dass** strukturierte Folienbahnen mit einer Länge von > 50m verwendet werden.

17. Verfahren nach einem der Ansprüche 11 bis 16, **dadurch gekennzeichnet, dass** die strukturierten Folienbahnen mit einer Toleranz < 100µm passgenau aufeinander laminiert werden.

18. Verfahren nach einem der Ansprüche 11 bis 17, **dadurch gekennzeichnet, dass** die strukturierte Transferfolie auf eine strukturierte Metallfolie (1) auflaminiert wird.

19. Verfahren nach einem der Ansprüche 11 bis 17, **dadurch gekennzeichnet, dass** die strukturierte Transferfolie auf eine strukturierte Kunststoff-Folie (4; 6) auflaminiert wird.

20. Verfahren nach einem der Ansprüche 11 bis 17, **dadurch gekennzeichnet, dass** die strukturierte Transferfolie auf einen Folienverbund auflaminiert wird.

21. Verwendung einer strukturierten Heißkleber-Folie nach einem der Ansprüche 1 bis 10 oder einer strukturierten Transferfolie nach einem der Ansprüche 11 bis 20 für die Herstellung eines Folienverbundes.

22. Verwendung einer strukturierten Heißkleber-Folie nach einem der Ansprüche 1 bis 10 oder einer strukturierten Transferfolie nach einem der Ansprüche 11 bis 20 für die Herstellung eines Folienverbundes für IC-Karten.

23. Verwendung einer strukturierten Heißkleber-Folie nach einem der Ansprüche 1 bis 10 oder einer strukturierten Transferfolie nach einem der Ansprüche 11 bis 20 für die Herstellung eines Folienverbundes für Halbleitersubstrate.

## Claims

1. Multilayer film consisting of at least two foil webs, wherein at least one foil web of the at least two foil webs is formed from a metal foil or plastic foil and at least one other foil web of the at least two foil webs is formed from a heat-activated adhesive foil adhesively active on both sides, **characterized in that** the at least one foil web configured as a metal foil (1) or plastic foil (4; 6) is textured, **in that** the foil web configured as a heat-activated adhesive foil (2; 2') is textured and **in that** at least the texture of the metal foils (1) or plastic foils (4; 6) that adjoin the heat-activated adhesive foil (2; 2') in the multilayer film is at least partly different from the texture of the heat- activated adhesive foil (2; 2').

2. Multilayer film consisting of at least two foil webs, wherein at least one foil web of the at least two foil webs is formed from a metal foil or plastic foil and at least one other foil web of the at least two foil webs is formed from a heat-activated adhesive foil adhesively active on both sides, **characterized in that** the at least one foil web configured as a metal foil (1) or plastic foil (4; 6) is textured, **in that** the foil web configured as a heat-activated adhesive foil (2; 2') is at least partly similarly textured and **in that** the texture of the metal foils (1) or plastic foils (4; 6) that adjoin the heat- activated adhesive foil (2; 2') in the multilayer film is offset with respect to the texture of the heat-activated adhesive foil (2; 2') at least in a part region of the similar texture.

3. Multilayer film according to Claim 1 or Claim 2, **characterized in that** the multilayer film is formed from at least one textured heat-activated adhesive foil (2; 2') and at least one textured metal foil (1 ).

4. Multilayer film according to any one of Claims 1 to 3, **characterized in that** the multilayer film is formed from at least one textured metal foil (1), at least one textured plastic foil (4; 6) and at least one textured heat-activated adhesive foil (2; 2').

5. Multilayer film according to any one of Claims 1 to 4, **characterized in that** the heat- activated adhesive of the heat-activated adhesive foil contains an electrically non- conductive filler.

6. Multilayer film according to any one of Claims 1 to 5, **characterized in that** the heat- activated adhesive foil is textured by stamping.

7. Multilayer film according to any one of Claims 1 to 5, **characterized in that** the heat- activated adhesive foil is textured by laser.

8. Multilayer film according to any one of Claims 1 to 7, **characterized in that** the textured foil webs have a length of > 1 m.

9. Multilayer film according to Claim 8, **characterized in that** the textured foil webs have a length of > 50 m.

10. Multilayer film according to any one of Claims 1 to 9, **characterized in that** the textured foil webs are laminated to each other precisely in register with a tolerance of < 100 µm.

11. Method for the production of a multilayer film consisting of at least two foil webs, wherein at least one foil web of the at least two foil webs is formed from a metal foil or plastic foil and at least one other foil web of the at least two foil webs is formed from a transfer foil formed from a carrier foil and a heat-activated adhesive foil adhesively active on both sides, **characterized in that** each of the at least two foil webs is textured, **in that** the textured transfer foil is brought together, in register, with a foil web configured as a metal foil (1) or plastic foil (4; 6) and at least partly differently textured from the transfer foil, **in that** the transfer foil with the heat-activated adhesive foil (2; 2') is laminated on to the foil web configured as a metal foil (1) or plastic foil (4; 6) and **in that** the carrier foil (3) is then stripped from the heat-activated adhesive foil (2; 2').

12. Method for the production of a multilayer did you consisting of at least two foil webs, wherein at least one foil web of the at least two foil webs is formed from a metal foil or plastic foil and at least one other foil web of the at least two foil webs is formed from a transfer foil formed from a carrier foil and a heat-activated adhesive foil adhesively active on both sides, **characterized in that** each of the at least two foil webs is textured, **in that** the textured transfer foil is brought together, in register, with a foil web configured as a metal foil (1) or plastic foil (4; 6) and at least partly similarly textured to the transfer foil, the texture of the metal foil (1) or plastic foil (4; 6) being offset with respect to the texture of the transfer foil at least in a part region of the similar texture, **in that** the transfer foil with the heat-activated adhesive foil (2; 2') is laminated on to the foil web configured as a metal foil (1) or plastic foil (4; 6) and **in that** the carrier foil (3) is then stripped from the heat-activated adhesive foil (2; 2').

13. Method according to Claim 11 or Claim 12, **characterized in that** the transfer foil is textured by stamping.

14. Method according to Claim 11 or Claim 12, **characterized in that** the transfer foil is textured by laser.

15. Method according to any one of Claims 11 to 14, **characterized in that** textured foil webs with a length of > 1 m are used.

16. Method according to any one of Claims 11 to 15, **characterized in that** textured foil webs with a length of > 50 m are used.

17. Method according to any one of Claims 11 to 16, **characterized in that** the textured foil webs are laminated to each other precisely in register with a tolerance of < 100 µm.

18. Method according to any one of Claims 11 to 17, **characterized in that** the textured transfer foil is laminated on to a textured metal foil (1 ).

19. Method according to any one of Claims 11 to 17, **characterized in that** the textured transfer foil is laminated on to a textured plastic foil (4; 6).

20. Method according to any one of Claims 11 to 17, **characterized in that** the textured transfer foil is laminated on to a textured multilayer film.

21. Use of a textured heat-activated adhesive foil according to any one of Claims 1 to 10 or textured transfer foil according to any one of Claims 11 to 20 for production of a multilayer film.

22. Use of a textured heat-activated adhesive foil according to any one of Claims 1 to 10 or textured transfer foil according to any one of Claims 11 to 20 for production of a multilayer film for integrated circuit boards.

23. Use of a textured heat-activated adhesive foil according to any one of Claims 1 to 10 or textured transfer foil according to any one of Claims 11 to 20 for production of a multilayer film for semiconductor substrates.

## Revendications

1. Feuille composite en au moins deux nappes de feuille, dans laquelle au moins une nappe de feuille desdites au moins deux nappes de feuille est formée par une feuille métallique ou par une feuille en matière plastique, et au moins une autre nappe de feuille desdites au moins deux nappes de feuille est formée par une feuille thermocollante activement adhésive sur les deux faces, **caractérisée en ce que** ladite au moins une nappe de feuille réalisée sous forme de feuille métallique (1) ou de feuille en matière plastique (4 ; 6) est structurée, **en ce que** la nappe de feuille réalisée sous forme de feuille thermocollante (2 ; 2') est structurée, et **en ce qu'**au moins la structuration de celles des feuilles métalliques (1) ou des feuilles de matière plastique (4 ; 6) qui sont adjacentes à la feuille thermocollante (2 ; 2') dans la feuille composite, est au moins partiellement différente de la structuration de la feuille thermocollante (2 ; 2').

2. Feuille composite en au moins deux nappes de feuille, dans laquelle au moins une nappe de feuille desdites au moins deux nappes de feuille est formée par une feuille métallique ou par une feuille en matière plastique, et au moins une autre nappe de feuille desdites au moins deux nappes de feuille est formée par une feuille thermocollante activement adhésive sur les deux faces, **caractérisée en ce que** ladite au moins une nappe de feuille réalisée sous forme de feuille métallique (1) ou de feuille en matière plastique (4 ; 6) est structurée, **en ce que** la nappe de feuille réalisée sous forme de feuille thermocollante (2 ; 2') est structurée au moins en partie de manière identique, et **en ce que** la structuration des feuilles métalliques (1) ou des feuilles de matière plastique (4 ; 6) qui sont adjacentes à la feuille thermocollante (2 ; 2') dans la feuille composite, est disposée, au moins dans une région partielle de la structuration identique, en décalage par rapport à la structuration de la feuille thermocollante (2 ; 2').

3. Feuille composite selon l'une ou l'autre des revendications 1 et 2, **caractérisée en ce que** la feuille composite est formée par au moins une feuille thermocollante (2 ; 2') structurée et par au moins une feuille métallique (1) structurée.

4. Feuille composite selon l'une des revendications 1 à 3, **caractérisée en ce que** la feuille composite est formée par au moins une feuille métallique (1) structurée, par au moins une feuille de matière plastique (4 ; 6) structurée et par au moins une feuille thermocollante (2 ; 2') structurée.

5. Feuille composite selon l'une des revendications 1 à 4, **caractérisée en ce que** la thermocolle de la feuille thermocollante contient une matière de charge non électroconductrice.

6. Feuille composite selon l'une des revendications 1 à 5, **caractérisée en ce que** la feuille thermocollante est structurée par poinçonnage.

7. Feuille composite selon l'une des revendications 1 à 5, **caractérisée en ce que** la feuille thermocollante est structurée par un laser.

8. Feuille composite selon l'une des revendications 1 à 7, **caractérisée en ce que** les nappes de feuille structurées ont une longueur de plus de 1 m.

9. Feuille composite selon la revendication 8, **caractérisée en ce que** les nappes de feuille structurées ont une longueur de plus de 50 m.

10. Feuille composite selon l'une des revendications 1 à 9, **caractérisée en ce que** les nappes de feuille structurées sont laminées l'une sur l'autre avec précision d'ajustage avec une tolérance de moins de 100µm.

11. Procédé de fabrication d'une feuille composite en au moins deux nappes de feuilles, dans lequel au moins une nappe de feuille desdites au moins deux nappes de feuilles est formée par une feuille métallique ou par une feuille de matière plastique et au moins une autre nappe de feuille desdites au moins deux nappes de feuilles est formée par une feuille de transfert, ladite feuille de transfert étant formée par une feuille support et par une feuille thermocollante activement adhésive sur les deux faces, **caractérisé en ce que** l'on structure chacune des au moins deux nappes de feuilles, **en ce que** l'on réunit en les posant bien l'une sur l'autre la feuille de transfert structurée avec une nappe de feuille réalisée sous forme de feuille métallique (1) ou de feuille de matière plastique (4 ; 6), structurée au moins partiellement de manière différente par rapport à la feuille de transfert, **en ce que** la feuille de transfert avec la feuille thermocollante (2 ; 2') est laminée sur la nappe de feuille réalisée en tant que feuille métallique (1) ou en tant que feuille de matière plastique (4 ; 6), et **en ce qu'**ensuite, on retire la feuille support (3) de la feuille thermocollante (2 ; 2').

12. Procédé de fabrication d'une feuille composite en au moins deux nappes de feuilles, dans lequel au moins une nappe de feuille desdites au moins deux nappes de feuilles est formée par une feuille métallique ou par une feuille de matière plastique et au moins une autre nappe de feuille desdites au moins deux nappes de feuilles est formée par une feuille de transfert, la feuille de transfert étant formée par une feuille support et par une feuille thermocollante activement adhésive sur les deux faces, **caractérisé en ce que** l'on structure chacune desdites au moins deux nappes de feuilles, **en ce que** l'on réunit en les posant bien l'une sur l'autre la feuille de transfert structurée avec une nappe de feuille réalisée en tant que feuille métallique (1) ou en tant que feuille de matière plastique (4 ; 6) et structurée au moins partiellement de manière identique à la feuille de transfert, la structuration de la feuille métallique (1) ou de la feuille en matière plastique (4 ; 6) étant disposée, au moins dans une région partielle de la structuration identique, en décalage par rapport à la structuration de la feuille de transfert, **en ce que** la feuille de transfert avec la feuille thermocollante (2 ; 2') est laminée sur la nappe de feuille réalisée en tant que feuille métallique (1) ou en tant que feuille en matière plastique (4 ; 6), et **en ce qu'**ensuite, on retire la feuille support (3) de la feuille thermocollante (2 ; 2').

13. Procédé selon l'une ou l'autre des revendications 11 et 12, **caractérisé en ce que** l'on structure la feuille de transfert par poinçonnage.

14. Procédé selon l'une ou l'autre des revendications 11 et 12, **caractérisé en ce que** l'on structure la feuille de transfert par un laser.

15. Procédé selon l'une des revendications 11 à 14, **caractérisé en ce que** l'on utilise des nappes de feuille structurées d'une longueur de plus de 1 m.

16. Procédé selon l'une des revendications 11 à 15, **caractérisé en ce que** l'on utilise des nappes de feuille structurées d'une longueur de plus de 50 m.

17. Procédé selon l'une des revendications 11 à 16, **caractérisé en ce que** les nappes de feuille structurées sont laminées l'une sur l'autre avec précision d'ajustage avec une tolérance de moins de 100µm.

18. Procédé selon l'une des revendications 11 à 17, **caractérisé en ce que** la feuille de transfert structurée est laminée sur une feuille métallique (1) structurée.

19. Procédé selon l'une des revendications 11 à 17, **caractérisé en ce que** la feuille de transfert structurée est laminée sur une feuille de matière plastique (4 ; 6) structurée.

20. Procédé selon l'une des revendications 11 à 17, **caractérisé en ce que** la feuille de transfert structurée est laminée sur une feuille composite.

21. Utilisation d'une feuille thermocollante structurée selon l'une des revendications 1 à 10 ou d'une feuille de transfert structurée selon l'une des revendications 11 à 20 pour la fabrication d'une feuille composite.

22. Utilisation d'une feuille thermocollante structurée selon l'une des revendications 1 à 10 ou d'une feuille de transfert structurée selon l'une des revendications 11 à 20 pour la fabrication d'une feuille composite pour des cartes à circuits intégrés.

23. Utilisation d'une feuille thermocollante structurée selon l'une des revendications 1 à 10 ou d'une feuille de transfert structurée selon l'une des revendications 11 à 20 pour la fabrication d'une feuille composite pour des substrats de semi-conducteurs.
